# EUROPEAN PATENT APPLICATION

(11) **EP 4 456 158 A1**
(43) Date of publication of application: **30.10.2024**
(21) Application number: 22911633.0
(22) Date of filing: 17.11.2022
(51) Int. Cl.: H01L 33/40, H01L 33/62, H01L 33/46, H01L 33/60, H01L 33/44, H01L 33/24

(54) **LIGHT-EMITTING DIODE**

(30) Priority: 23.12.2021 KR 20210186296; 24.12.2021 KR 20210186933; 15.11.2022 KR 20220152659
(71) Applicant: Seoul Viosys Co., Ltd., Ansan-si, Gyeonggi-do 15429 (KR)
(72) Inventor: OH, Se Hee, Ansan-Si Gyeonggi-do 15429 (KR); KIM, Kyoung Wan, Ansan-Si Gyeonggi-do 15429 (KR); KIM, Hae Yu, Ansan-Si Gyeonggi-do 15429 (KR)
(74) Representative: Stolmár & Partner Patentanwälte PartG mbB
(86) International application number: PCT/KR2022/018208
(87) International publication number: WO 2023/120996

(57) **Abstract**

A light-emitting diode according to an embodiment comprises: a substrate; a first conductive-type semiconductor layer disposed on the substrate; a mesa disposed on the first conductive-type semiconductor layer and including an active layer and a second conductive-type semiconductor layer; an ohmic contact layer disposed on the second conductive-type semiconductor layer and formed by islands which are spaced apart from each other; a dielectric layer covering the ohmic contact layer and having openings through which the respective islands are exposed; a metal reflective layer covering the dielectric layer and electrically connected to the islands through the openings of the dielectric layer; a lower insulating layer covering the metal reflective layer and having an opening through which the metal reflective layer is exposed; and first and second bump pads disposed on the lower insulating layer and electrically connected to the first and second conductive-type semiconductor layers, respectively.

## Description

### [Technical Field]

The present disclosure relates to a light emitting diode, and more particularly to a light emitting diode with an improved reflection structure.

### [Background Art]

In general, since nitrides of group III elements such as gallium nitride (GaN), aluminum nitride (AlN), and the like have favorable thermal stability and have a direct transition energy band structure, they have recently attracted a lot of attention as light source materials in the visible and ultraviolet regions. In particular, blue and green light emitting diodes using indium gallium nitride (InGaN) have been used in various application fields such as large-scale color flat panel displays, traffic lights, indoor lighting, high-density light sources, high-resolution output systems, optical communications, and others.

Meanwhile, a flip-chip type light emitting diode has favorable heat dissipation performance and it has been used as a high output light emitting diode. The flip-chip type light emitting diode has a structure in which light generated in an active layer is emitted to the outside through a substrate, and has bump pads opposite to the substrate. In addition, the flip-chip type light emitting diode generally employs a reflection layer reflecting light generated in the active layer toward the substrate.

### [Disclosure]

### [Technical Problem]

Exemplary embodiments of the present disclosure provide a light emitting diode with an improved reflection structure to improve light extraction efficiency.

Exemplary embodiments of the present disclosure provide a light emitting diode with high reliability.

### [Technical Solution]

A light emitting diode according to an embodiment of the present disclosure includes a substrate; a first conductivity type semiconductor layer disposed on the substrate; a mesa disposed on the first conductivity type semiconductor layer, and including an active layer and a second conductivity type semiconductor layer; an ohmic contact layer disposed on the second conductivity type semiconductor layer and formed of islands spaced apart from one another; a dielectric layer covering the ohmic contact layer, and having openings respectively exposing the islands; a metal reflection layer covering the dielectric layer, and electrically connected to the islands through the openings of the dielectric layer; a lower insulation layer covering the metal reflection layer, and having an opening exposing the metal reflection layer; and first and second bump pads disposed over the lower insulation layer, and electrically connected to the first and second conductivity type semiconductor layers, respectively.

The dielectric layer may cover the islands and the second conductivity type semiconductor layer exposed between the islands, and the openings of the dielectric layer exposing the ohmic contact layer may be respectively disposed on the islands to partially expose the islands.

Each of the islands may have a circular shape, a diameter of each of the islands may exceed four times of diameters of the openings of the dielectric layer, and an interval between the islands may be equal to or larger than the diameters of the openings.

In an embodiment, the interval between the islands may be smaller than the diameter of the island.

In an embodiment, the lower insulation layer may include a distributed Bragg reflector.

The light emitting diode may further include: a first pad metal layer disposed on the lower insulation layer, and electrically connected to the first conductivity type semiconductor layer; and a second pad metal layer disposed on the lower insulation layer, and electrically connected to the metal reflection layer through the opening of the lower insulation layer.

The light emitting diode further may further include an upper insulation layer covering the first pad metal layer and the second pad metal layer, and including a first opening exposing the first pad metal layer and a second opening exposing the second pad metal layer, in which the first and second bump pads may be electrically connected to the first and second pad metal layers through the first and second openings, respectively.

The mesa may have via holes exposing the first conductivity type semiconductor layer, the dielectric layer and the lower insulation layer may be formed to expose the first conductivity type semiconductor layer in the via holes, and the first pad metal layer may have internal contact portions contacting the first conductivity type semiconductor layer in the via holes.

Furthermore, the mesa may have a side surface having recess portions, and an edge of the lower insulation layer may be formed along an edge of the mesa to expose the first conductivity type semiconductor layer along a periphery of the mesa, and the pad metal layer may have external contact portions contacting the first conductivity type semiconductor layer near the recess portions.

In addition, the first pad metal layer may further include an external contact portion contacting the first conductivity type semiconductor layer near at least some of edges of the substrate.

The light emitting diode may further include a rim dielectric layer laterally spaced apart from the dielectric layer and disposed along an edge of the first conductivity type semiconductor layer.

The rim dielectric layer may be formed of a same material as that of the dielectric layer.

In addition, the rim dielectric layer may be laterally spaced from the lower insulation layer.

The light emitting diode may further include: a first pad metal layer disposed on the lower insulation layer, and electrically connected to the first conductivity type semiconductor layer; and a second pad metal layer disposed on the lower insulation layer, and electrically connected to the metal reflection layer through the opening of the lower insulation layer, in which the rim dielectric layer may be laterally spaced apart from the first pad metal layer.

The light emitting diode may further include an upper insulation layer covering the first pad metal layer and the second pad metal layer, and including a first opening exposing the first pad metal layer and a second opening exposing the second pad metal layer, in which the first and second bump pads may be electrically connected to the first and second pad metal layers through the first and second openings, respectively, and the upper insulation layer may cover the rim dielectric layer.

The ohmic contact layer may be formed of a conductive oxide layer, and further, the conductive oxide layer may be ITO (Indium Tin Oxide).

A light emitting diode according to an embodiment of the present disclosure includes: a first conductivity type semiconductor layer; a mesa disposed on the first conductivity type semiconductor layer, and including an active layer and a second conductivity type semiconductor layer; an ohmic contact layer disposed on the second conductivity type semiconductor layer and formed of islands spaced apart from one another; a dielectric layer covering the ohmic contact layer, and having openings respectively exposing the islands; a metal reflection layer covering the dielectric layer, and electrically connected to the islands through the openings of the dielectric layer; and a lower insulation layer covering the metal reflection layer, and having an opening exposing the metal reflection layer.

The ohmic contact layer may be formed of ITO.

The dielectric layer and the lower insulation layer may cover a side surface of the mesa, and may partially cover the first conductivity type semiconductor layer exposed around the mesa along an edge of the mesa

A light emitting diode according to an embodiment of the present disclosure includes: a substrate; a first conductivity type semiconductor layer disposed on the substrate; a mesa disposed on the first conductivity type semiconductor layer, and including an active layer and a second conductivity type semiconductor layer; a current blocking layer disposed on the second conductivity type semiconductor layer and formed of islands spaced apart from one another; an ohmic contact layer covering the current blocking layer and contacting the second conductivity type semiconductor layer; a dielectric layer covering the ohmic contact layer, and having openings respectively exposing the ohmic contact layer on the islands; a metal reflection layer covering the dielectric layer and electrically connected to the ohmic contact layer through the openings of the dielectric layer; a lower insulation layer covering the metal reflection layer, and having an opening exposing the metal reflection layer; and first and second bump pads disposed over the lower insulation layer, and electrically connected to the first and second conductivity type semiconductor layers, respectively.

The ohmic contact layer may cover the islands and the second conductivity type semiconductor layer exposed between the islands, and each of the openings of the dielectric layer exposing the ohmic contact layer may have a size smaller than those of the islands and expose the ohmic contact layer on the islands.

Each of the islands may have a circular shape, a diameter of each of the islands may exceed four times of diameters of the openings of the dielectric layer, and an interval between the islands may be equal to or larger than the diameters of the openings.

In an embodiment, the interval between the islands may be smaller than the diameter of the island.

In an embodiment, the lower insulation layer may include a distributed Bragg reflector.

The light emitting diode may further include: a first pad metal layer disposed on the lower insulation layer, and electrically connected to the first conductivity type semiconductor layer; and a second pad metal layer disposed on the lower insulation layer, and electrically connected to the metal reflection layer through the opening of the lower insulation layer.

The light emitting diode further may further include an upper insulation layer covering the first pad metal layer and the second pad metal layer, and including a first opening exposing the first pad metal layer and a second opening exposing the second pad metal layer, in which the first and second bump pads may be electrically connected to the first and second pad metal layers through the first and second openings, respectively.

The mesa may have via holes exposing the first conductivity type semiconductor layer, the dielectric layer and the lower insulation layer may be formed to expose the first conductivity type semiconductor layer within the via holes, and the first pad metal layer may have internal contact portions contacting the first conductivity type semiconductor layer within the via holes.

Furthermore, the mesa may have a side surface having recess portions, and an edge of the lower insulation layer may be formed along an edge of the mesa to expose the first conductivity type semiconductor layer along a periphery of the mesa, and the pad metal layer may have external contact portions contacting the first conductivity type semiconductor layer near the recess portions.

In addition, the first pad metal layer may further include an external contact portion contacting the first conductivity type semiconductor layer near at least some of edges of the substrate.

The light emitting diode may further include a rim dielectric layer laterally spaced apart from the dielectric layer and disposed along an edge of the first conductivity type semiconductor layer.

The rim dielectric layer may be formed of a same material as that of the dielectric layer.

In addition, the rim dielectric layer may be laterally spaced from the lower insulation layer.

The light emitting diode may further include: a first pad metal layer disposed on the lower insulation layer, and electrically connected to the first conductivity type semiconductor layer; and a second pad metal layer disposed on the lower insulation layer, and electrically connected to the metallic reflection layer through the opening of the lower insulation layer, in which the rim dielectric layer may be laterally spaced apart from the first pad metal layer.

The light emitting diode may further include an upper insulation layer covering the first pad metal layer and the second pad metal layer, and including a first opening exposing the first pad metal layer and a second opening exposing the second pad metal layer, in which the first and second bump pads may be electrically connected to the first and second pad metal layers through the first and second openings, respectively, and the upper insulation layer may cover the rim dielectric layer.

The ohmic contact layer may be formed of a conductive oxide layer, and further, the conductive oxide layer may be ITO (Indium Tin Oxide).

A light emitting diode according to an embodiment of the present disclosure includes: a first conductivity type semiconductor layer; a mesa disposed on the first conductivity type semiconductor layer, and including an active layer and a second conductivity type semiconductor layer; a current blocking layer disposed on the second conductivity type semiconductor layer and formed of islands spaced apart from one another; an ohmic contact layer covering the current blocking layer and contacting the second conductivity type semiconductor layer; a dielectric layer covering the ohmic contact layer, and having openings respectively exposing the islands on the islands; a metal reflection layer covering the dielectric layer, and electrically connected to the ohmic contact layer through the openings of the dielectric layer; and a lower insulation layer covering the metal reflection layer, and having an opening exposing the metal reflection layer.

The ohmic contact layer may be formed of ITO.

The dielectric layer and the lower insulation layer may cover a side surface of the mesa, and may partially cover the first conductivity type semiconductor layer exposed around the mesa along an edge of the mesa.

### [Description of Drawings]

FIG. 1A is a schematic plan view illustrating a light emitting diode according to an embodiment of the present disclosure.
FIG. 1B is a partial enlarged view of FIG. 1A.
FIG. 2A is a cross-sectional view taken along line A-A' in FIG. 1A.
FIG. 2B is a cross-sectional view taken along line B-B' in FIG. 1A.
FIG. 3 is a schematic partial enlarged cross-sectional view illustrating a reflection structure according to an embodiment of the present disclosure.
FIG. 4 is a schematic partial enlarged cross-sectional view illustrating a rim dielectric layer of a light emitting diode according to an embodiment of the present disclosure.
FIG. 5A is a schematic plan view illustrating a light emitting diode according to an embodiment of the present disclosure.
FIG. 5B is a partial enlarged view of FIG. 5A.
FIG. 6A is a cross-sectional view taken along line C-C' in FIG. 5A.
FIG. 6B is a cross-sectional view taken along line D-D' in FIG. 5A.
FIG. 7 is a schematic partial enlarged cross-sectional view illustrating a reflection structure according to an embodiment of the present disclosure.
FIG. 8 is a schematic partial enlarged cross-sectional view illustrating a rim dielectric layer of a light emitting diode according to an embodiment of the present disclosure.
FIG. 9A is a perspective view illustrating a light emitting diode package to which a light emitting diode according to an embodiment of the present disclosure is applied.
FIG. 9B is a plan view of FIG. 9A.
FIG. 9C is a cross-sectional view taken along line I-I' in FIG. 9B.
FIG. 10 is a cross-sectional view illustrating a display apparatus to which a light emitting diode according to an embodiment of the present disclosure is applied.
FIG. 11 is a cross-sectional view illustrating a display apparatus to which a light emitting diode according to another embodiment of the present disclosure is applied.
FIG. 12 is a cross-sectional view illustrating an example of applying a light emitting diode to a headlamp according to another embodiment of the present disclosure.
FIGs. 13A, 13B, and 13C are a schematic cross-sectional view, a plan view, and a circuit diagrams illustrating a display apparatus to which a light emitting diode according to another embodiment of the present disclosure is applied.

### [Best Mode]

Hereinafter, exemplary embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the exemplary embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be " directly disposed above" or " directly disposed on" the other element or layer or intervening elements or layers can be present. Throughout the specification, like reference numerals denote like elements having the same or similar functions.

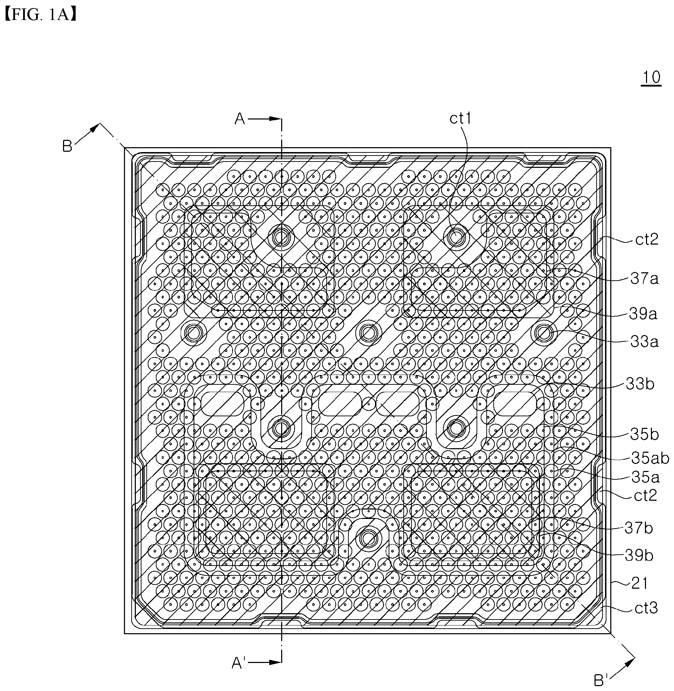

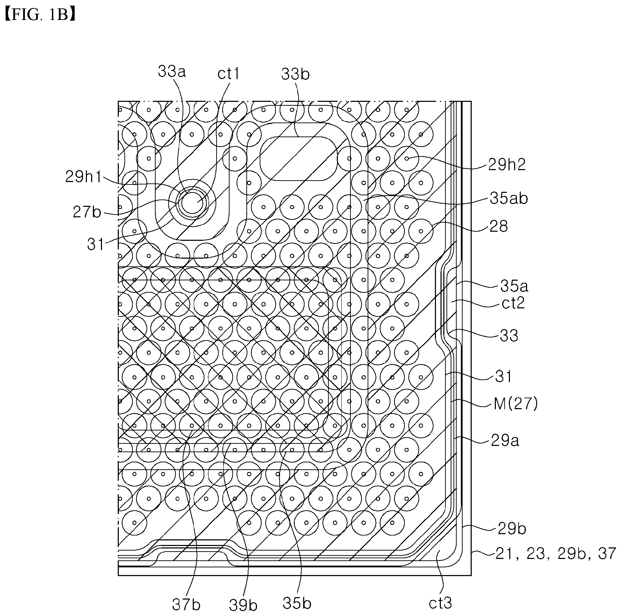

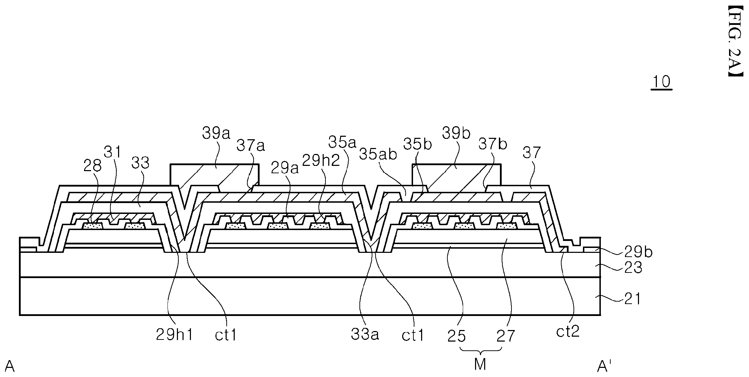

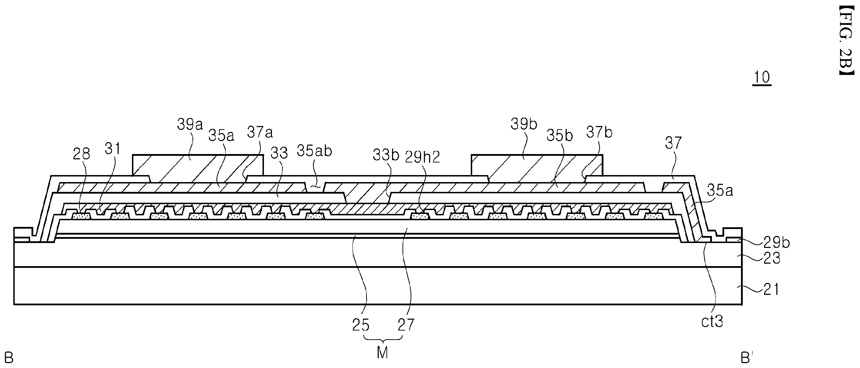

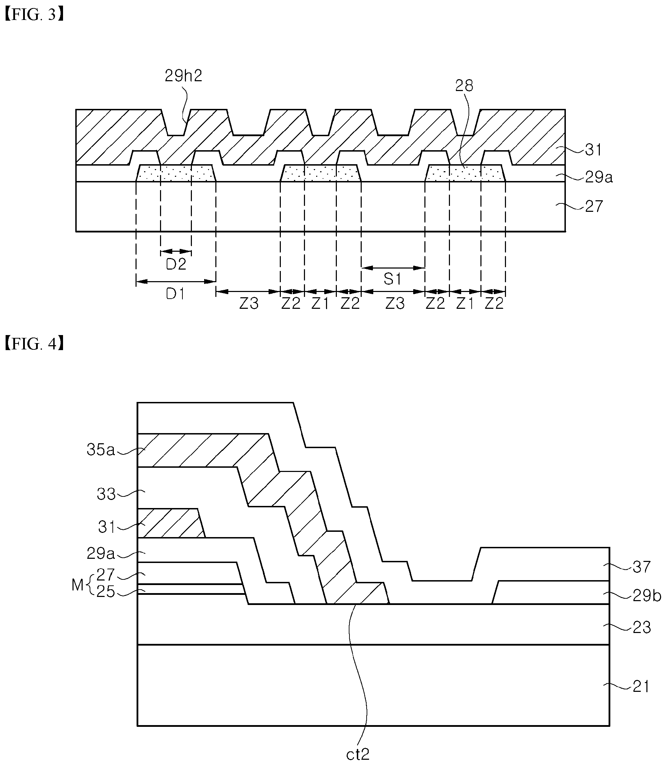

FIG. 1A is a schematic plan view illustrating a light emitting diode 10 according to an embodiment of the present disclosure, and FIG. 1B is a partial enlarged view of FIG. 1A. FIG. 2 is a cross-sectional view taken along line A-A' of FIG. 1A, and FIG. 3 is a cross-sectional view taken along line B-B' of FIG. 1A. Meanwhile, FIG. 3 is a schematic partial enlarged cross-sectional view illustrating a reflection structure according to an embodiment of the present disclosure, and FIG. 4 is a schematic partial enlarged cross-sectional view illustrating a rim dielectric layer 29b of the light emitting diode 10 according to an embodiment of the present disclosure.

First, referring to FIGs. 1A, 1B, 2A, and 2B, the light emitting diode 10 includes a substrate 21, a first conductivity type semiconductor layer 23, an active layer 25, a second conductivity type semiconductor layer 27, an ohmic contact layer 28, a dielectric layer 29a, a metal reflection layer 31, a lower insulation layer 33, a first pad metal layer 35a, a second pad metal layer 35b, and an upper insulation layer 37. Furthermore, the light emitting diode 10 may further include a first bump pad 39a and a second bump pad 39b.

The substrate 21 is not particularly limited as long as it is a substrate capable of growing a gallium nitride-based semiconductor layer. Examples of the substrate 21 may be various such as a sapphire substrate, a gallium nitride substrate, a SiC substrate, and the like. The substrate 21 may have a rectangular or square outer shape as shown in plan view of FIG. 1A, but is not necessarily limited thereto. A size of the substrate 21 is not particularly limited and may be selected in various ways.

The first conductivity type semiconductor layer 23 is disposed on the substrate 21. The first conductivity type semiconductor layer 23 is a layer grown on the substrate 21, and may be a gallium nitride-based semiconductor layer. The first conductivity type semiconductor layer 23 may be a gallium nitride-based semiconductor layer doped with an impurity, for example, Si.

An edge of the first conductivity type semiconductor layer 23 may be in flush with an edge of the substrate 21. However, the inventive concepts are not limited thereto, and the first conductivity type semiconductor layer 23 may be disposed inside a region surrounded by the edge of the substrate 21.

A mesa M is disposed on the first conductivity type semiconductor layer 23. The mesa M may be disposed within the region surrounded by the first conductivity type semiconductor layer 23, and thus, regions near the edge of the first conductivity type semiconductor layer 23 may be exposed to the outside without being covered by the mesa M. In addition, as shown in FIG. 1A and 1B, the mesa M may include recess portions along an edge thereof. An upper surface of the first conductivity type semiconductor layer 23 is exposed in the recess portions.

The mesa M includes the second conductivity type semiconductor layer 27 and the active layer 25. The active layer 25 is interposed between the first conductivity type semiconductor layer 23 and the second conductivity type semiconductor layer 27. The active layer 25 may have a single quantum well structure or a multi quantum well structure. A composition and a thickness of a well layer in the active layer 25 determines a wavelength of light generated. In particular, by adjusting the composition of the well layer, an active layer that generates ultraviolet rays, blue light, or green light may be provided. In this embodiment, the active layer 25 may specifically generate ultraviolet rays or blue light of 500 nm or less, and may further generate visible light within a range of 400 nm to 470 nm.

Meanwhile, the second conductivity type semiconductor layer 27 may be a gallium nitride-based semiconductor layer doped with a p-type impurity, for example, Mg. Each of the first conductivity type semiconductor layer 23 and the second conductivity type semiconductor layer 27 may be a single layer, without being limited thereto, may be multiple layers, and may include a superlattice layer. The first conductivity type semiconductor layer 23, the active layer 25, and the second conductivity type semiconductor layer 27 may be formed by being grown on the substrate 21 in a chamber using a known method such as metal organic chemical vapor deposition (MOCVD) process or molecular beam epitaxy (MBE).

Meanwhile, as shown in FIGs. 1A, 1B, and 2B, the mesa M may include a plurality of via holes 27b passing through the second conductivity type semiconductor layer 27 and the active layer 25 to expose the first conductivity type semiconductor layer 23. The via holes 27b are spaced apart from one another within a mesa M region. In an embodiment, the via holes 27b may be spaced apart from one another at regular intervals, and may be evenly distributed within the mesa M region. The via holes 27b may be arranged in multiple rows or multiple columns. Although eight via holes 27b are shown in the drawings, the inventive concepts are not limited thereto. As the number of via holes 27b increases, the number of internal contact portions ct1 of the first pad metal layer 35a increases and current spreading performance may be improved. In an embodiment, at least one via hole 27b may be disposed between bump pads of a same polarity, for example, the first bump pads 39a or the second bump pads 39b, and at least one via hole 27b may be disposed between bump pads of different polarities, for example, between the first bump pad 39a and the second bump pad 39b.

Meanwhile, the ohmic contact layer 28 is disposed over the mesa M and contacts the second conductivity type semiconductor layer 27. The ohmic contact layer 28 is formed of a plurality of islands. When the substrate 21 is a patterned sapphire substrate, the islands may be partially arranged in a same form as that of a protruding pattern on the substrate 21. For example, the islands may be arranged in a honeycomb shape. The islands may include curved regions, or as shown in the drawings, may be circular. A surface of the second conductivity type semiconductor layer 27 may be exposed between the islands. The islands may be distributed over almost an entire region of the mesa M in an upper region of the mesa M. However, an interval between the islands (S 1 in FIG. 3) may be smaller than an interval between the island and the via hole 27b or an interval between the island and the edge of the mesa M. The interval S 1 between the islands may be, for example, in a range of 1 um to 5 um, without being limited thereto. Meanwhile, diameters D1 of the islands may be, for example, in a range of 5 um to 10 um, without being limited thereto. By forming the ohmic contact layer 28 with the islands spaced apart from one another, light absorption by the ohmic contact layer 28 may be reduced, thereby improving a luminous intensity of the light emitting diode.

The ohmic contact layer 28 may be formed of a conductive oxide layer that transmits light generated in the active layer 25. The ohmic contact layer 28 may be formed of, for example, ITO (indium tin oxide), ZnO, or the like. The ohmic contact layer 28 is formed to have a thickness sufficient to be in ohmic contact with the second conductivity type semiconductor layer 27, and for example, it may be formed within a thickness range of 3 nm to 50 nm, specifically, within a thickness range of 6 nm to 30 nm. When the thickness of the ohmic contact layer 28 is too small, it does not provide sufficient ohmic characteristics and a forward voltage increases. In addition, when the thickness of the ohmic contact layer 28 is too large, loss due to light absorption occurs, thereby reducing luminous efficiency.

Meanwhile, the dielectric layer 29a covers the ohmic contact layer 28. Furthermore, the dielectric layer 29a may cover the second conductivity type semiconductor layer 27 exposed between the islands, and may cover a side surface of the mesa M. The dielectric layer 29a may partially cover the first conductivity type semiconductor layer 23 exposed around the mesa M along the edge of the mesa M. An edge of the dielectric layer 29a may be covered with the lower insulation layer 33, which will be described later. Therefore, the edge of the dielectric layer 29a is disposed farther from the edge of the substrate 21 than an edge of the lower insulation layer 33. Accordingly, as it will be described later, a portion of the lower insulation layer 33 may be in contact with the first conductivity type semiconductor layer 23 around the mesa M. Moreover, the dielectric layer 29a may be defined within an upper region of the second conductivity type semiconductor layer 27, and the lower insulation layer 33 may be in contact with side surfaces of the second conductivity type semiconductor layer 27 and the active layer 25.

The dielectric layer 29a may have openings 29h1 exposing the first conductivity type semiconductor layer 23 and openings 29h2 exposing the ohmic contact layer 28 in the via holes 27b. The dielectric layer 29a may have a plurality of openings 29h2 exposing each of the islands. The openings 29h1 may be formed in the via holes 27b. The openings 29h1 are formed to provide a connection passage through which the first pad metal layer 35a can be connected to the first conductivity type semiconductor layer 23.

The openings 29h2 may be disposed on each of the islands 28, and may partially expose the islands 28. The openings 29h2 provide a connection passage through which the metal reflection layer 31 can connect to the ohmic contact layer 28. Diameters of the openings 29h2 (D2 in FIG. 3) are small compared to those of the islands. A width of each of the openings 29h2 may be less than half of a width of a corresponding island. Furthermore, the diameter D2 of the island may be 5 times or more and less than 10 times of the diameter of the opening 29h2.

The dielectric layer 29a is formed of an insulating material having a refractive index lower than those of the second conductivity type semiconductor layer 27 and the ohmic contact layer 28. The dielectric layer 29a may be formed of, for example, SiO₂.

The rim dielectric layer 29b may be spaced apart from the dielectric layer 29a and disposed along the edge of the first conductivity type semiconductor layer 23. The first conductivity type semiconductor layer 23 may be exposed between the dielectric layer 29a and the rim dielectric layer 29b. An outer edge of the rim dielectric layer 29b may be in flush with the edge of the substrate 21. When the substrate 21 is exposed to a periphery of the first conductivity type semiconductor layer 23, the rim dielectric layer 29b may be disposed along the edge of the substrate 21.

The rim dielectric layer 29b may be formed of a same material as that of the dielectric layer 29a. The rim dielectric layer 29b may be formed together with the dielectric layer 29a. For example, after forming a dielectric layer, the dielectric layer 29a and the rim dielectric layer 29b spaced apart from each other may be formed by patterning the dielectric layer using photolithography and etching processes.

Meanwhile, the metal reflection layer 31 is disposed on the dielectric layer 29a and connected to the ohmic contact layer 28 through the openings 29h2. The metal reflection layer 31 may be disposed in the upper region of the mesa M. The metal reflection layer 31 includes a reflective metal, for example, Ag or Ni/Ag. Furthermore, the metal reflection layer 31 may include a barrier layer, such as Ni, to protect a reflective metal material layer, and may also include an Au layer to prevent oxidation of the metallic layer. Moreover, to improve an adhesion of the Au layer, a Ti layer may be included below the Au layer. The metal reflection layer 31 is in contact with an upper surface of the dielectric layer 29a.

By forming an ohmic contact with the ohmic contact layer 28 and disposing the metal reflection layer 31 on the dielectric layer 29a, it is possible to prevent ohmic resistance from increasing due to solder, and others. Furthermore, by disposing the ohmic contact layer 28, the dielectric layer 29a, and the metal reflection layer 31 on the second conductivity type semiconductor layer 27, reflectance of light may be improved, thereby improving luminous efficiency. In particular, light loss due to the ohmic contact layer 28 may be reduced by forming the ohmic contact layer 28 with the islands.

Referring to FIG. 3, a plurality of sections in which a refractive index thereof changes is laterally formed between the metal reflection layer 31 and the active layer 25. A refractive index of GaN is 2.4, a refractive index of the ohmic contact layer 28, such as ITO, is about 2.0, and a refractive index of the dielectric layer 29a, such as SiO₂, is about 1.5, which may be divided into Z1, Z2, and Z3 depending on the lateral section where the refractive index changes. Z1 has a constant refractive index in a lateral direction, for example, the refractive index of the ohmic contact layer 28, Z2 has a refractive index in which the ohmic contact layer 28 and the dielectric layer 29a are stacked, and Z3 has the refractive index of the dielectric layer 29a. Within the Z1, the ohmic contact layer 28 has a constant thickness, and within the Z2, thicknesses of the ohmic contact layer 28 and the dielectric layer 28a may change. In addition, the thickness of the dielectric layer 28a within the Z3 may change in the lateral direction. Accordingly, when the dielectric layer 29a is a SiO2 single layer, the Z2 which is a section where the ohmic contact layer 28 and the dielectric layer 29a overlap, is formed between the Z1 and the Z3, and the refractive index within the Z2 may be changed multiple times in the lateral direction. The Z1 to Z3 may be repeatedly arranged in a horizontal direction on an upper surface of the substrate 21. That is, they may be symmetrically repeated on both sides of a central axis (C1) of the Z1, or may be symmetrically repeated on both sides of a central axis (C3) of the Z3. Alternatively, they may be arranged such that an arrangement of Z1-Z2-Z3-Z2 is repeated.

The dielectric layer 29a may have a stacked structure in which SiO₂ and TiO₂ are repeated. The section Z2 in which a refractive index thereof changes most in the lateral direction may be arranged between the section Z1 in which a refractive index and a thickness thereof are constant and the section Z3 in which a refractive index thereof is constant but a thickness thereof changes. In addition, it may be symmetrically repeated on both sides of the central axis (C1) of the Z1, or may be symmetrically repeated on both sides of the central axis (C3) of the Z3. Alternatively, it may be arranged such that the arrangement of Z1-Z2-Z3-Z2 is repeated.

A light emitting diode with this structure may be effective when the Z1 to Z3 are arranged below a light exiting surface. That is, when the device is bonded such that the substrate 21 becomes the light exiting surface, a portion of light generated in the active layer 25 may be emitted in a direction opposite to the light exiting surface, but a plurality of Z1 to Z3 reflects and spreads light to increase light extraction efficiency.

The lower insulation layer 33 covers the mesa M and the metal reflection layer 31. The lower insulation layer 33 may also partially cover the first conductivity type semiconductor layer 23 along a periphery of the mesa M, and may partially cover the first conductivity type semiconductor layer 23. The lower insulation layer 33 covers the side surface of the mesa M in particular. The lower insulation layer 33 may also cover the dielectric layer 29a. However, the lower insulation layer 33 may be laterally spaced apart from the rim dielectric layer 29b. For example, the edge of the lower insulation layer 33 may be disposed between the edge of the dielectric layer 29a and an inner edge of the rim dielectric layer 29b. Since the lower insulation layer 33 is spaced apart from the rim dielectric layer 29b, it is possible to prevent a crack from occurring in the lower insulation layer 33 during a breaking process for singularizing light emitting diode chips.

Meanwhile, the lower insulation layer 33 exposes the first conductivity type semiconductor layer 23 near the side surface of the mesa M and in the via holes 27b. The lower insulation layer 33 may have openings 33a exposing the first conductivity type semiconductor layer 23 and openings 33b exposing the metal reflection layer 31. In addition, the lower insulation layer 33 may partially expose the first conductivity type semiconductor layer 23 around the mesa M along a side shape of the mesa M, and thus, more regions of the first conductivity type semiconductor layer 23 may be exposed in the recess portions.

In this embodiment, the lower insulation layer 33 is formed to expose all peripheral regions including the edge of the first conductivity type semiconductor layer 23. However, the inventive concepts are not limited thereto, and the openings of the lower insulation layer 33 may be formed near the recess portions of the side surface of the mesa M.

The openings 33a of the lower insulation layer 33 may expose the first conductivity type semiconductor layer 23 in the openings 29h1 of the dielectric layer 29a. Meanwhile, the opening 33b of the lower insulation layer 33 exposes the metal reflection layer 31. The number and the position of the openings 33b may be changed in various ways. The metal reflection layer 31 exposed by the openings 33b of the lower insulation layer 33 may have a flat surface, and for this purpose, the islands 28 may be laterally spaced apart from the openings 33b such that the openings 33b and the islands 28 do not overlap one another. However, the inventive concepts are not necessarily limited thereto, and the openings 33b and the islands 28 may overlap one another.

Meanwhile, the lower insulation layer 33 may include a distributed Bragg reflector. The distributed Bragg reflector may be formed by stacking insulation layers with different refractive indices. For example, the distributed Bragg reflector may be formed by alternately stacking silicon nitride films and silicon oxide films. When the lower insulation layer 33 includes the distributed Bragg reflector, the lower insulation layer 33 is relatively thick compared to the rim dielectric layer 29b, and may be vulnerable to cracks. By spacing the lower insulation layer 33 from the rim dielectric layer 29b in the lateral direction, cracks may be prevented from occurring at the edges of the lower insulation layer 33.

The first pad metal layer 35a is disposed on the lower insulation layer 33, and insulated from the mesa M and the metal reflection layer 31 by the lower insulation layer 33. The first pad metal layer 35a contacts the first conductivity type semiconductor layer 23 exposed by the lower insulation layer 33. The first pad metal layer 35a may include a first contact portion ct1 contacting the first conductivity type semiconductor layer 23 in the via holes 27a, and second and third contact portions ct2 and ct3 contacting the first conductivity type semiconductor layer 23 along the periphery of the mesa M. The first contact portion ct1 contacting the first conductivity type semiconductor layer 23 in the via holes 27a is a contact portion disposed inside the mesa M and may be called an internal contact portion, and the second and third contact portions ct2 and ct3 are contact portions disposed outside the mesa M and may be called external contact portions.

The second contact portions ct2 may be disposed along the edge of the mesa M. As shown in FIG. 1A, a plurality of second contact portions ct2 may be spaced apart from one another and disposed near the recess portions of the mesa M. As shown in FIG. 1A, a shortest distance between the first contact portions ct1 and the second contact portions ct2 may be greater than a shortest distance from the first contact portions ct1 to the edge of the mesa M, and thus, current spreading performance may be improved.

The third contact portions ct3 are disposed near the edges of the mesa M. A shortest distance between the first contact portions ct1 and the third contact portions ct3 may be greater than the shortest distance between the first contact portions ct1 and the second contact portions ct2, and may be greater than a shortest distance between the first contact portions ct1. The third contact portions ct3 may be disposed near edges close to the second pad metal layer 35b among the edges of the mesa M, and contribute to current spreading performance by supplementing the first contact portions ct1.

Meanwhile, the second pad metal layer 35b is disposed in the upper region of the mesa M on the lower insulation layer 33, and electrically connected to the metal reflection layer 31 through the opening 33b of the lower insulation layer 33. The second pad metal layer 35b may be surrounded by the first pad metal layer 35a, and a boundary region 35ab may be formed between them. The lower insulation layer 33 is exposed in the boundary region 35ab, and this boundary region 35ab is covered with the upper insulation layer 37, which will be described later.

The first pad metal layer 35a and the second pad metal layer 35b may be formed together with a same material in a same process. The first and second pad metal layers 35a and 35b may include an ohmic reflection layer such as an Al layer, and the ohmic reflection layer may be formed on an adhesive layer such as Ti, Cr, Ni, or the like. In addition, a protection layer having a single or multiple layer structure of Ni, Cr, Au, and the like may be formed on the ohmic reflection layer. The first and second pad metal layers 35a and 35b may have a multilayer structure of, for example, Cr/Al/Ni/Ti/Ni/Ti/Au/Ti.

The upper insulation layer 37 covers the first and second pad metal layers 35a and 35b. In addition, the upper insulation layer 37 may cover the first conductivity type semiconductor layer 23 along the periphery of the mesa M. As it is well shown in FIG. 4, the upper insulation layer 37 may cover the rim dielectric layer 29b. The upper insulation layer 37 may cover an entire first conductivity type semiconductor layer 23, and may be in flush with the edge of the substrate 21. Since the upper insulation layer 37 and the rim dielectric layer 29b are formed by being overlapped with each other, the first conductivity type semiconductor layer 23 may be prevented from being exposed even when a crack occurs in the upper insulation layer 37. Furthermore, since a step is generated near an edge of the upper insulation layer 37 by the rim dielectric layer 29b, even when a crack occurs at the edge of the upper insulation layer 37, it is possible to prevent the crack from progressing into an interior of the light emitting diode chip.

The upper insulation layer 37 may have first openings 37a exposing the first pad metal layer 35a and second openings 37b exposing the second pad metal layer 35b. The first openings 37a and the second openings 37b may be disposed in the upper region of the mesa M, and may be disposed opposite each other. In this embodiment, a plurality of first openings 37a and a plurality of second openings 37b are shown and described, but one first opening 37a and one second opening 37b may be formed, respectively.

The upper insulation layer 37 may be formed as a single layer of SiO₂ or Si₃N₄, without being limited thereto, and may include a SiO₂-TiO₂ mixed layer or an MgF₂ layer. The SiO₂-TiO₂ mixed layer or the MgF₂ layer has favorable waterproof characteristics and may improve the reliability of light emitting diode in high temperature and high humidity environments. In addition, the upper insulation layer 37 may have a multilayer structure including silicon nitride films and silicon oxide films, and may also include a distributed Bragg reflector in which silicon oxide films and titanium oxide films are alternately stacked.

Meanwhile, the first bump pads 39a electrically contact the first pad metal layer 35a exposed through the first openings 37a of the upper insulation layer 37, and the second bump pads 39b electrically contacts the second pad metal layer 35b exposed through the second openings 37b. As shown in FIG. 1A and 1B, the first bump pad 39a and the second bump pad 39b may cover and seal the first opening 37a and the second opening 37b, respectively. However, the inventive concepts are not limited thereto, and the first bump pad 39a may be disposed in the first opening 37a of the upper insulation layer 37, and the second bump pad 39b may be disposed in the second opening 37b of the upper insulation layer 37. The second bump pad 39b may be laterally spaced apart from the second opening 33b of the lower insulation layer 33.

As shown in FIG. 1A, the second bump pad 39b may be disposed within an upper region of the second pad metal layer 35a. However, the inventive concepts are not limited thereto, and a portion of the second bump pad 39b may overlap the first pad metal layer 35a. However, the upper insulation layer 37 may be disposed between the first pad metal layer 35a and the second bump pad 39b to insulate them.

According to an embodiment of the present disclosure, the reflection structure of the ohmic contact layer 28, the dielectric layer 29a, and the metal reflection layer 31 is used instead of a conventional ohmic reflection layer. Accordingly, the infiltration of bonding materials such as solder into a contact region may be prevented, and stable ohmic contact resistance may be secured to improve the reliability of the light emitting diode 10. Furthermore, by forming the ohmic contact layer 28 with the islands, light absorption by the ohmic contact layer 28 may be reduced and the light extraction efficiency of the light emitting diode 10 may be improved.

### (Experimental Example)

A light emitting diode was manufactured by patterning an ohmic contact layer 28 into a plurality of islands (Inventive Example 1). Meanwhile, to compare with the light emitting diode of Inventive Example 1, a light emitting diode (Comparative Example 1) in which the ohmic contact layer 28 was formed as a continuous layer without patterning was manufactured. The light emitting diodes of Comparative Example 1 and Inventive Example 1 had same components except for the ohmic contact layer 28.

As a result of measuring luminous intensities of the light emitting diodes of Inventive Example 1 and Comparative Example 1 through an integrating sphere, it was found that the light emitting diode of Inventive Example 1 had a relatively high luminous intensity compared to that of the light emitting diode of Comparative Example 1. Meanwhile, as a result of measuring electrical characteristics using a probe, a forward voltage of the light emitting diode of Inventive Example 1 was relatively higher than that of the light emitting diode of Comparative Example 1.

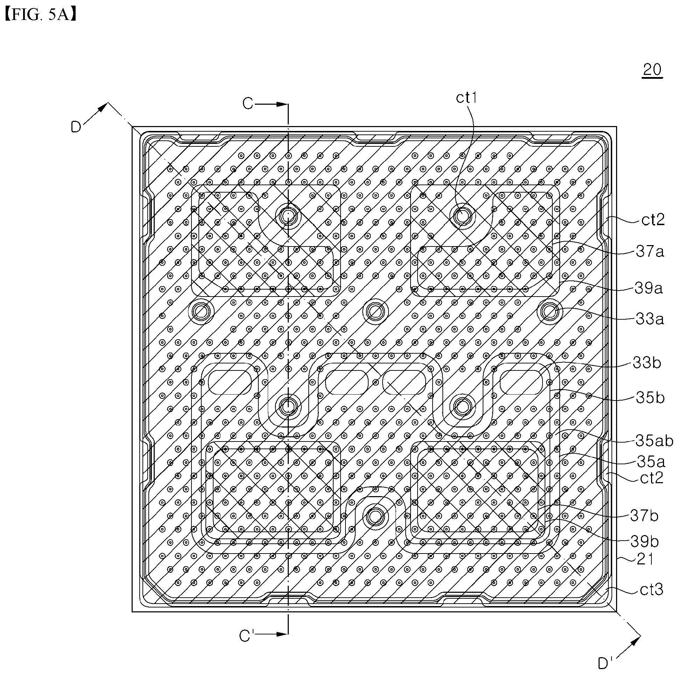

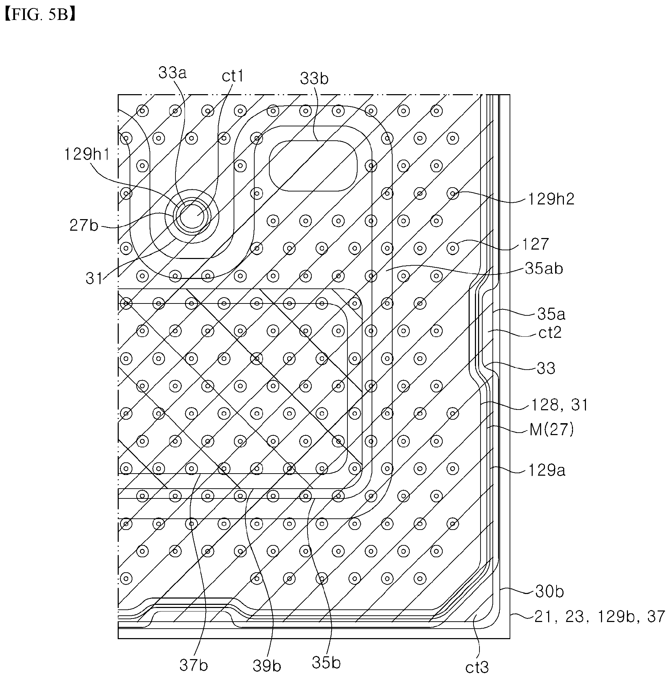

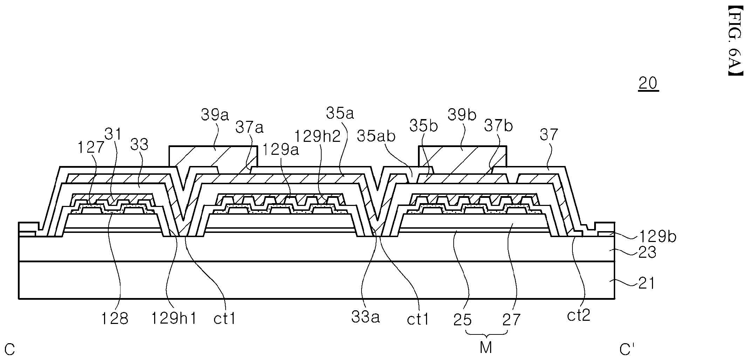

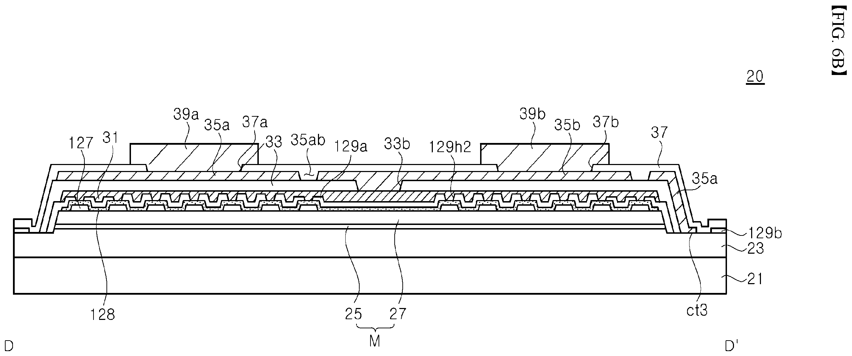

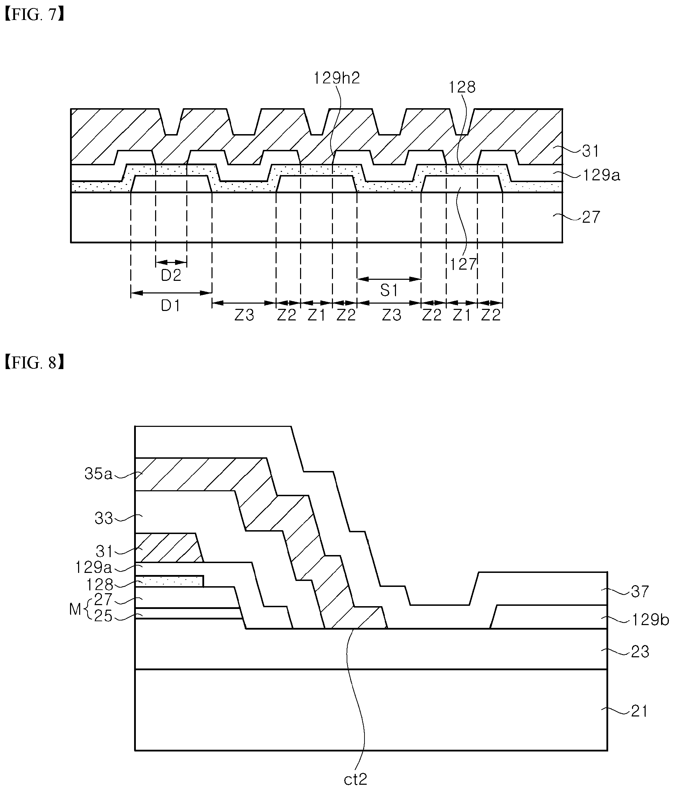

FIG. 5A is a schematic plan view illustrating a light emitting diode 20 according to an embodiment of the present disclosure, and FIG. 5B is a partial enlarged view of FIG. 5A. FIG. 6A is a cross-sectional view taken along line C-C' of FIG. 5A, and FIG. 6B is a cross-sectional view taken along line D-D' of FIG. 5A. Meanwhile, FIG. 7 is a schematic partial enlarged cross-sectional view illustrating a reflection structure according to an embodiment of the present disclosure, and FIG. 8 is a schematic partial view illustrating a rim dielectric layer 129b of a light emitting diode according to an embodiment of the present disclosure.

First, referring to FIGs. 5A, 5B, 6A, and 6B, the light emitting diode 20 includes a substrate 21, a first conductivity type semiconductor layer 23, an active layer 25, and a second conductivity type semiconductor layer 27, a current blocking layer 127, an ohmic contact layer 128, a dielectric layer 129a, a rim dielectric layer 129b, a metal reflection layer 31, a lower insulation layer 33, a first pad metal layer 35a, a second pad metal layer 35b, and an upper insulation layer 37. Furthermore, the light emitting diode 20 may further include a first bump pad 39a and a second bump pad 39b.

The substrate 21 is not particularly limited as long as it is a substrate capable of growing a gallium nitride-based semiconductor layer. Examples of the substrate 21 may be various such as a sapphire substrate, a gallium nitride substrate, a SiC substrate, and the like. The substrate 21 may have a rectangular or square outer shape as shown in plan view FIG. 5A, but is not necessarily limited thereto. A size of the substrate 21 is not particularly limited and may be selected in various ways.

The first conductivity type semiconductor layer 23 is disposed on the substrate 21. The first conductivity type semiconductor layer 23 is a layer grown on the substrate 21, and may be a gallium nitride-based semiconductor layer. The first conductivity type semiconductor layer 23 may be a gallium nitride-based semiconductor layer doped with an impurity, for example, Si.

An edge of the first conductivity type semiconductor layer 23 may be in flush with an edge of the substrate 21. However, the inventive concepts are not limited thereto, and the first conductivity type semiconductor layer 23 may be disposed inside a region surrounded by the edge of the substrate 21.

A mesa M is disposed on the first conductivity type semiconductor layer 23. The mesa M may be disposed within the region surrounded by the first conductivity type semiconductor layer 23, and thus, regions near the edge of the first conductivity type semiconductor layer 23 may be exposed to the outside without being covered by the mesa M. In addition, as shown in FIGs. 5A and 5B, the mesa M may include recess portions along an edge thereof. An upper surface of the first conductivity type semiconductor layer 23 is exposed in the recess portions.

The mesa M includes the second conductivity type semiconductor layer 27 and the active layer 25. The active layer 25 is interposed between the first conductivity type semiconductor layer 23 and the second conductivity type semiconductor layer 27. The active layer 25 may have a single quantum well structure or a multi quantum well structure. A composition and a thickness of a well layer in the active layer 25 determines a wavelength of light generated. In particular, by adjusting the composition of the well layer, an active layer that generates ultraviolet rays, blue light, or green light may be provided. In this embodiment, the active layer 25 may specifically generate ultraviolet rays or blue light of 500 nm or less, and may further generate visible light within a range of 400 nm to 470 nm.

Meanwhile, the second conductivity type semiconductor layer 27 may be a gallium nitride-based semiconductor layer doped with a p-type impurity, for example, Mg. Each of the first conductivity type semiconductor layer 23 and the second conductivity type semiconductor layer 27 may be a single layer, without being limited thereto, may be multiple layers, and may include a superlattice layer. The first conductivity type semiconductor layer 23, the active layer 25, and the second conductivity type semiconductor layer 27 may be formed by being grown on the substrate 21 in a chamber using a known method such as metal organic chemical vapor deposition (MOCVD) process or molecular beam epitaxy (MBE).

Meanwhile, as shown in FIGs. 5A and 6B, the mesa M may include a plurality of via holes 27b passing through the second conductivity type semiconductor layer 27 and the active layer 25 to expose the first conductivity type semiconductor layer 23. The via holes 27b are spaced apart from one another within a mesa M region. In an embodiment, the via holes 27b may be spaced apart from one another at regular intervals, and may be evenly distributed within the mesa M region. Although eight via holes 27b are shown, the inventive concepts are not limited thereto. As the number of via holes 27b increases, the number of internal contact portions ct1 of the first pad metal layer 35a increases and current spreading performance may be improved.

Meanwhile, the ohmic contact layer 128 is disposed over the mesa M and contacts the second conductivity type semiconductor layer 27. Meanwhile, the current blocking layer 127 is disposed between the ohmic contact layer 128 and the second conductivity type semiconductor layer 27.

The current blocking layer 127 is formed of a plurality of islands. A surface of the second conductivity type semiconductor layer 27 may be exposed between the islands. The islands may be distributed over almost an entire region of the mesa M in an upper region of the mesa M. However, an interval between the islands (S1 in FIG. 7) may be smaller than an interval between the island and the via hole 27b or an interval between the island and the edge of the mesa M. The interval S1 between the islands may be, for example, in a range of 1 um to 5 um, without being limited thereto. Meanwhile, diameters D1 of the islands may be, for example, in a range of 5 um to 10 um, without being limited thereto.

The ohmic contact layer 128 covers the current blocking layer 127 and contacts the second conductivity type semiconductor layer 27 exposed between the islands of the current blocking layer 127. By disposing the current blocking layer 127 between the ohmic contact layer 128 and the second conductivity type semiconductor layer 27, current spreading performance may be improved and light absorption by the ohmic contact layer 128 may be reduced, thereby improving a luminous intensity of the light emitting diode.

The current blocking layer 127 may be formed of oxide or nitride that transmits light generated in the active layer 25. The current blocking layer 127 is formed of an insulating material.

The ohmic contact layer 128 may be formed of a conductive oxide layer that transmits light generated in the active layer 25. The ohmic contact layer 128 may be formed of, for example, ITO (indium tin oxide), ZnO, or the like. The ohmic contact layer 128 is formed to have a thickness sufficient to be in ohmic contact with the second conductivity type semiconductor layer 27, and for example, it may be formed within a thickness range of 3 nm to 50 nm, specifically, within a thickness range of 6 nm to 30 nm. When the thickness of the ohmic contact layer 128 is too small, it does not provide sufficient ohmic characteristics and a forward voltage increases. In addition, when the thickness of the ohmic contact layer 128 is too large, loss due to light absorption occurs, thereby reducing luminous efficiency.

Meanwhile, the dielectric layer 129a covers the ohmic contact layer 128. Furthermore, the dielectric layer 129a may cover a side surface of the mesa M. The dielectric layer 129a may partially cover the first conductivity type semiconductor layer 23 exposed around the mesa M along the edge of the mesa M. An edge of the dielectric layer 129a may be covered with the lower insulation layer 33, which will be described later. Therefore, the edge of the dielectric layer 129a is disposed farther from an edge of the substrate 21 than an edge of the lower insulation layer 33. Accordingly, as it will be described later, a portion of the lower insulation layer 33 may be in contact with the first conductivity type semiconductor layer 23 around the mesa M. Moreover, the dielectric layer 129a may be defined within an upper region of the second conductivity type semiconductor layer 27, and the lower insulation layer 33 may be in contact with side surfaces of the second conductivity type semiconductor layer 27 and the active layer 25.

The dielectric layer 129a may have openings 129h1 exposing the first conductivity type semiconductor layer 23 and openings 129h2 exposing the ohmic contact layer 128 in the via holes 27b. The dielectric layer 129a may have a plurality of openings 129h2 exposing each of the islands. The openings 129h1 may be formed in the via holes 27b. The openings 129h1 are formed to provide a connection passage through which the first pad metal layer 35a can be connected to the first conductivity type semiconductor layer 23.

The openings 129h2 may be disposed on the islands of the current blocking layer 127, respectively, and may partially expose the ohmic contact layer 20. The openings 129h2 provide a connection passage through which the metal reflection layer 31 can connect to the ohmic contact layer 128. Diameters of the openings 129h2 (D2 in FIG. 7) are smaller than those of the islands, and for example, the diameter D2 of the island may be 5 times or more and less than 10 times of the diameter of the opening 129h2.

The dielectric layer 129a is formed of an insulating material having a refractive index lower than those of the second conductivity type semiconductor layer 27 and the ohmic contact layer 128. The dielectric layer 129 may be formed of, for example, SiO₂.

The rim dielectric layer 129b may be spaced apart from the dielectric layer 129a and disposed along the edge of the first conductivity type semiconductor layer 23. The first conductivity type semiconductor layer 23 may be exposed between the dielectric layer 129a and the rim dielectric layer 129b. An outer edge of the rim dielectric layer 129b may be in flush with the edge of the substrate 21. When the substrate 21 is exposed around the first conductivity type semiconductor layer 23, the rim dielectric layer 129b may be disposed along the edge of the substrate 21.

The rim dielectric layer 129b may be formed of a same material as that of the dielectric layer 129a. The rim dielectric layer 129b may be formed together with the dielectric layer 129a. For example, after forming a dielectric layer, the dielectric layer 129a and the rim dielectric layer 129b spaced apart from each other may be formed by patterning the dielectric layer using photolithography and etching processes.

Meanwhile, the metal reflection layer 31 is disposed on the dielectric layer 129a and connected to the ohmic contact layer 128 through the openings 129h2. The metal reflection layer 31 may be disposed in the upper region of the mesa M. The metal reflection layer 31 includes a reflective metal, for example, Ag or Ni/Ag. Furthermore, the metal reflection layer 31 may include a barrier layer, such as Ni, to protect a reflective metal material layer, and may also include an Au layer to prevent oxidation of the metallic layer. Moreover, to improve an adhesion of the Au layer, a Ti layer may be included below the Au layer. The metal reflection layer 31 is in contact with an upper surface of the dielectric layer 129a.

By forming an ohmic contact with the ohmic contact layer 128 and disposing the metal reflection layer 31 on the dielectric layer 129a, it is possible to prevent ohmic resistance from increasing due to solder, and others. Furthermore, by disposing the ohmic contact layer 128, the dielectric layer 129a, and the metal reflection layer 31 on the second conductivity type semiconductor layer 27, reflectance of light may be improved, thereby improving luminous efficiency. In particular, by disposing the current blocking layer 127 between the ohmic contact layer 128 and the second conductivity type semiconductor layer 27, light loss due to the ohmic contact layer 128 may be reduced.

Referring to FIG. 7, a plurality of sections in which a refractive index thereof changes is laterally formed between the metal reflection layer 31 and the active layer 25. A refractive index of GaN is 2.4, a refractive index of the ohmic contact layer 128, such as ITO, is about 2.0, and a refractive index of the dielectric layer 129a, such as SiO₂, is about 1.5, which may be divided into Z1, Z2, and Z3 depending on the lateral section where the refractive index changes. Z1 has a constant refractive index in a lateral direction, for example, refractive indices of the current blocking layer 127 and the ohmic contact layer 128, Z2 has a refractive index in which the current blocking layer 127, the ohmic contact layer 128, and the dielectric layer 129a are stacked, and Z3 has the refractive indices of the ohmic contact layer 128 and the dielectric layer 129a. Within the Z1, the current blocking layer 127 and the ohmic contact layer 128 have a constant thickness, and within the Z2, thicknesses of the current blocking layer 127, the ohmic contact layer 128, and the dielectric layer 129a may change. In addition, the thicknesses of the ohmic contact layer 128 and the dielectric layer 129a within the Z3 may change in the lateral direction. The Z2, a section where the current blocking layer 127, the ohmic contact layer 128, and the dielectric layer 129a overlap, is formed between the Z1 and the Z3, and the refractive index within the Z2 may be changed multiple times in the lateral direction. The Z1 to Z3 may be repeatedly arranged in a horizontal direction on an upper surface of the substrate 21. That is, they may be symmetrically repeated on both sides of a central axis (C1) of the Z1, or may be symmetrically repeated on both sides of a central axis (C3) of the Z3. Alternatively, they may be arranged such that an arrangement of Z1-Z2-Z3-Z2 is repeated.

The dielectric layer 129a may have a SiO₂ single layer or a stacked structure in which SiO₂ and TiO₂ are repeated. In an embodiment, the section Z2 in which a refractive index thereof changes most in the lateral direction may be arranged between the section Z1 in which a refractive index and a thickness thereof are constant and the section Z3 in which a refractive index thereof is constant but a thickness thereof changes.

A light emitting diode with this structure may be effective when the Z1 to Z3 are arranged below a light exiting surface. That is, when the device is bonded such that the substrate 21 becomes the light exiting surface, a portion of light generated in the active layer 25 may be emitted in a direction opposite to the light exiting surface, but a plurality of Z1 to Z3 reflects and spreads light to increase light extraction efficiency.

The lower insulation layer 33 covers the mesa M and the metal reflection layer 31. The lower insulation layer 33 may also partially cover the first conductivity type semiconductor layer 23 along a periphery of the mesa M, and may partially cover the first conductivity type semiconductor layer 23. The lower insulation layer 33 covers the side surface of the mesa M in particular. The lower insulation layer 33 may also cover the dielectric layer 129a. However, the lower insulation layer 33 may be laterally spaced apart from the rim dielectric layer 129b. For example, the edge of the lower insulation layer 33 may be disposed between the edge of the dielectric layer 129a and an inner edge of the rim dielectric layer 129b. Since the lower insulation layer 33 is spaced apart from the rim dielectric layer 129b, it is possible to prevent a crack from occurring in the lower insulation layer 33 during a breaking process for singularizing light emitting diode chips.

Meanwhile, the lower insulation layer 33 exposes the first conductivity type semiconductor layer 23 near the side surface of the mesa M and within the via holes 27b. The lower insulation layer 33 may have openings 33a exposing the first conductivity type semiconductor layer and openings 33b exposing the metal reflection layer 31. In addition, the lower insulation layer 33 may partially expose the first conductivity type semiconductor layer 23 around the mesa M along a side shape of the mesa M, and thus, more regions of the first conductivity type semiconductor layer 23 may be exposed in the recess portions.

In this embodiment, the lower insulation layer 33 is formed to expose all peripheral regions including the edge of the first conductivity type semiconductor layer 23. However, the inventive concepts are not limited thereto, and the openings of the lower insulation layer 33 may be formed near the recess portions of the side surface of the mesa M.

The openings 33a of the lower insulation layer 33 may expose the first conductivity type semiconductor layer 23 in the openings 129h1 of the dielectric layer 129a. Meanwhile, the opening 33b of the lower insulation layer 33 exposes the metal reflection layer 31. The number and the position of the openings 33b may be changed in various ways. The metal reflection layer 31 exposed by the openings 33b of the lower insulation layer 33 may have a flat surface, and for this purpose, the islands 127 may be laterally spaced apart from the openings 33b such that the openings 33b and the islands 127 do not overlap one another. However, the inventive concepts are not necessarily limited thereto, and the openings 33b and the islands 127 may overlap one another.

Meanwhile, the lower insulation layer 33 may include a distributed Bragg reflector. The distributed Bragg reflector may be formed by stacking insulation layers with different refractive indices. For example, the distributed Bragg reflector may be formed by alternately stacking silicon nitride films and silicon oxide films. When the lower insulation layer 33 includes the distributed Bragg reflector, the lower insulation layer 33 is relatively thick compared to the dielectric layer 129b, and may be vulnerable to cracks. By spacing the lower insulation layer 33 from the rim dielectric layer 129b in the lateral direction, cracks may be prevented from occurring at the edges of the lower insulation layer 33.

The first pad metal layer 35a is disposed on the lower insulation layer 33, and insulated from the mesa M and the metal reflection layer 31 by the lower insulation layer 33. The first pad metal layer 35a contacts the first conductivity type semiconductor layer 23 exposed by the lower insulation layer 33. The first pad metal layer 35a may include a first contact portion ct1 contacting the first conductivity type semiconductor layer 23 within the via holes 27a, and second and third contact portions ct2 and ct3 contacting the first conductivity type semiconductor layer 23 along the periphery of the mesa M. The first contact portion ct1 contacting the first conductivity type semiconductor layer 23 in the via holes 27a is a contact portion disposed inside the mesa M and may be called an internal contact portion, and the second and third contact portions ct2 and ct3 are contact portions disposed outside the mesa M and may be called external contact portions.

The second contact portions ct2 may be disposed along the edge of the mesa M. As shown in FIG. 5A, a plurality of second contact portions ct2 may be spaced apart from one another and disposed near the recess portions of the mesa M. As shown in FIG. 5A, a shortest distance between the first contact portions ct1 and the second contact portions ct2 may be greater than a shortest distance from the first contact portions ct1 to the edge of the mesa M, and thus, current spreading performance may be improved.

The third contact portions ct3 are disposed near the edges of the mesa M. A shortest distance between the first contact portions ct1 and the third contact portions ct3 may be greater than the shortest distance between the first contact portions ct1 and the second contact portions ct2, and may be greater than a shortest distance between the first contact portions ct1. The third contact portions ct3 may be disposed near edges close to the second pad metal layer 35b among the edges of the mesa M, and contribute to current spreading performance by supplementing the first contact portions ct1.

Meanwhile, the second pad metal layer 35b is disposed in the upper region of the mesa M on the lower insulation layer 33, and electrically connected to the metal reflection layer 31 through the opening 33b of the lower insulation layer 33. The second pad metal layer 35b may be surrounded by the first pad metal layer 35a, and a boundary region 35ab may be formed between them. The lower insulation layer 33 is exposed in the boundary region 35ab, and this boundary region 35ab is covered with the upper insulation layer 37, which will be described later.

The first pad metal layer 35a and the second pad metal layer 35b may be formed together with a same material in a same process. The first and second pad metal layers 35a and 35b may include an ohmic reflection layer such as an Al layer, and the ohmic reflection layer may be formed on an adhesive layer such as Ti, Cr, Ni, or the like. In addition, a protection layer having a single or multilayer structure of Ni, Cr, Au, and the like may be formed on the ohmic reflection layer. The first and second pad metal layers 35a and 35b may have a multilayer structure of, for example, Cr/Al/Ni/Ti/Ni/Ti/Au/Ti.

The upper insulation layer 37 covers the first and second pad metal layers 35a and 35b. In addition, the upper insulation layer 37 may cover the first conductivity type semiconductor layer 23 along the periphery of the mesa M. As it is well shown in FIG. 8, the upper insulation layer 37 may cover the rim dielectric layer 129b. The upper insulation layer 37 may cover an entire first conductivity type semiconductor layer 23, and may be in flush with the edge of the substrate 21. Since the upper insulation layer 37 and the rim dielectric layer 129b are formed by being overlapped with each other, the first conductivity type semiconductor layer 23 may be prevented from being exposed even when a crack occurs in the upper insulation layer 37. Furthermore, since a step is generated near the edge of the upper insulation layer 37 by the rim dielectric layer 129b, even when a crack occurs at the edge of the upper insulation layer 37, it is possible to prevent the crack from progressing into an interior of the light emitting diode chip.

The upper insulation layer 37 may have first openings 37a exposing the first pad metal layer 35a and second openings 37b exposing the second pad metal layer 35b. The first openings 37a and the second openings 37b may be disposed in the upper region of the mesa M, and may be disposed opposite each other. In this embodiment, a plurality of first openings 37a and a plurality of second openings 37b are shown and described, but only one first and second openings 37a and 37b may be formed, respectively.

The upper insulation layer 37 may be formed as a single layer of SiO₂ or Si₃N₄, without being limited thereto, and may include a SiO₂-TiO₂ mixed layer or an MgF₂ layer. The SiO₂-TiO₂ mixed layer or an MgF₂ layer has favorable waterproof characteristics and may improve the reliability of light emitting diode in high temperature and high humidity environments. In addition, the upper insulation layer 37 may have a multilayer structure including silicon nitride films and silicon oxide films, and may also include a distributed Bragg reflector in which silicon oxide films and titanium oxide films are alternately stacked.

Meanwhile, the first bump pads 39a electrically contact the first pad metal layer 35a exposed through the first openings 37a of the upper insulation layer 37, and the second bump pads 39b electrically contacts the second pad metal layer 35b exposed through the second openings 37b. As shown in FIG. 1A and 1B, the first bump pad 39a and the second bump pad 39b may cover and seal the first opening 37a and the second opening 37b, respectively. However, the inventive concepts are not limited thereto, and the first bump pad 39a may be disposed in the first opening 37a of the upper insulation layer 37, and the second bump pad 39b may be disposed in the second opening 37b of the upper insulation layer 37. The second bump pad 39b may be laterally spaced apart from the second opening 33b of the lower insulation layer 33.

As shown in FIG. 5A, the second bump pad 39b may be disposed within an upper region of the second pad metal layer 35a. However, the inventive concepts are not limited thereto, and a portion of the second bump pad 39b may overlap the first pad metal layer 35a. However, the upper insulation layer 37 may be disposed between the first pad metal layer 35a and the second bump pad 39b to insulate them.

According to an embodiment of the present disclosure, the reflection structure of the ohmic contact layer 128, the dielectric layer 129a, and the metal reflection layer 31 is used instead of a conventional ohmic reflection layer. Accordingly, the infiltration of bonding materials such as solder into a contact region may be prevented, and stable ohmic contact resistance may be secured to improve the reliability of the light emitting diode. Furthermore, by forming the ohmic contact layer 128 with the islands, light absorption by the ohmic contact layer 128 may be reduced and light extraction efficiency of the light emitting diode may be improved.

### (Experimental Example)

Alight emitting diode was manufactured by patterning the current blocking layer 127 into a plurality of islands (Inventive Example 2). Meanwhile, to compare with the light emitting diode of Inventive Example 2, a light emitting diode (Comparative Example 2) in which the current blocking layer 127 was omitted was manufactured. The light emitting diodes of Comparative Example 2 and Inventive Example 2 had same components except for the current blocking layer 127.

As a result of measuring luminous intensities of the light emitting diodes of Inventive Example 2 and Comparative Example 2 through an integrating sphere, it was found that the light emitting diode of Inventive Example 2 had a relatively high luminous intensity compared to that of the light emitting diode of Comparative Example 2. Meanwhile, as a result of measuring electrical characteristics using a probe, a forward voltage of the light emitting diode of Inventive Example 2 was relatively higher than that of the light emitting diode of Comparative Example 2.

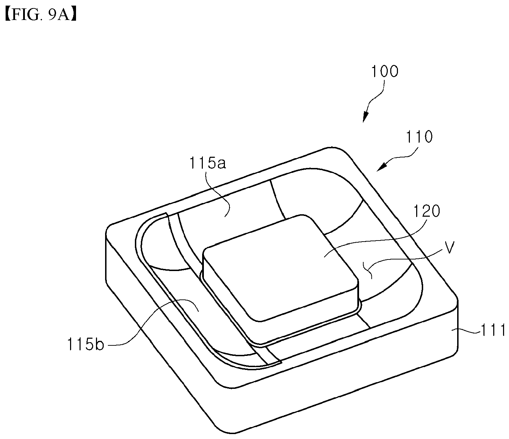

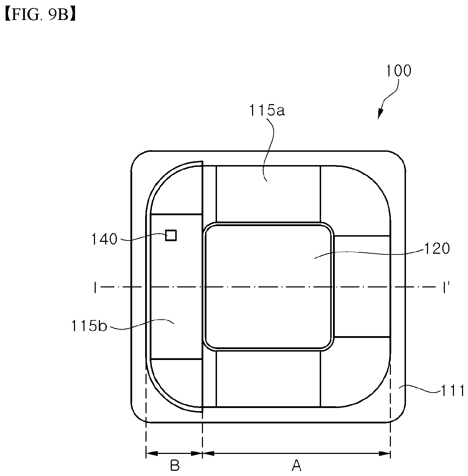

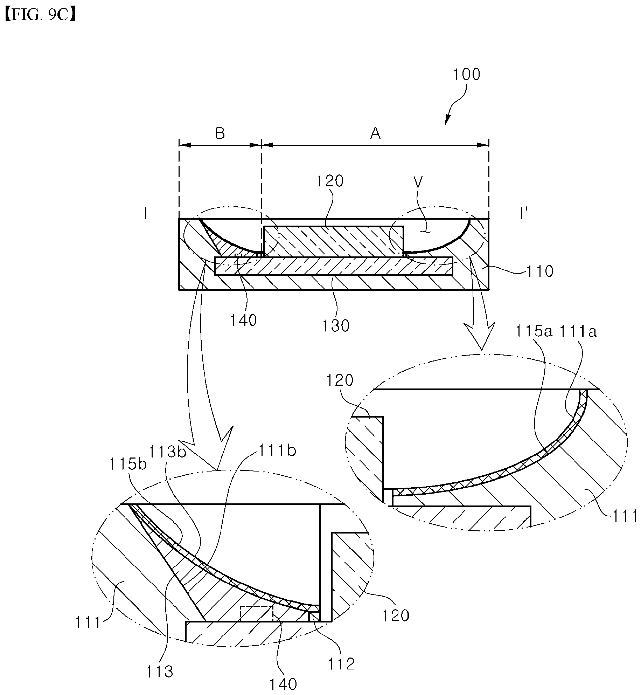

FIG. 9A is a perspective view illustrating a light emitting diode package to which a light emitting diode according to an embodiment of the present disclosure is applied, FIG. 9B is a plan view of FIG. 9A, and FIG. 9C is a cross-sectional view taken along line I-I' of FIG. 9B.

Referring to FIGs. 9A, 9B, and 9C, a light emitting diode package 100 includes a housing 110, a light emitting diode chip 120, a lead frame 130, and a Zener diode 140.

In this embodiment, the housing 110 includes a body portion 111, a cover portion 113, and a coating portion 115. As shown in the drawings, the body portion 111 has a substantially rectangular shape on a plane, and may have a shape surrounding the lead frame 130 to support the lead frame 130. The housing 110 may have a cavity V with one side open inside, and the light emitting diode chip 120 may be disposed in the cavity V

Herein, a depth of the cavity V may be greater than a height of the light emitting diode chip 120. In this case, as shown in FIGs. 9B and 9C, the body portion 111 may be divided into a region A and a region B. The region A may be a region where the light emitting diode chip 120 is mounted, and the region B may be a region where the Zener diode 140 is mounted.

Looking at the region A of the body portion 111, an inclined surface of the cavity V surrounding the light emitting diode chip 120 may have a same inclined surface with respect to the light emitting diode chip 120. In this case, a first body inclined surface 111a formed in the region A may be formed as a curved surface, as shown in FIG. 9C, and may be formed such that an inclination of the curved surface becomes steeper toward an upper portion thereof.

The first body inclined surface 111a formed in the region A is formed on the cavities V of three surfaces of the light emitting diode chip 120 except for one surface of the light emitting diode chip 120. In this case, an inner side of the first body inclined surface 111a may be disposed adjacent to a position where the light emitting diode chip 120 is mounted. Accordingly, light emitted from the light emitting diode chip 120 may be reflected from the first body inclined surface 111a and emitted upward of the light emitting diode package 100.

In this embodiment, a second body inclined surface 111b formed in the region B, as shown in FIG. 9C, may have a linear cross-sectional shape. However, when the first body inclined surface 111a is formed as an inclined surface, the cross-sectional shape is not limited to being a linear shape, and may also be formed as a curved cross-sectional shape.

In this case, as it can be seen in FIG. 9B, the region B may have a width in a vertical direction greater than a width in a vertical direction of the region A. Although this will be described later, this is to secure a space in which the cover portion 113 can be formed to cover the second body inclined surface 111b.

As shown in FIG. 9C, the cover portion 113 is arranged to cover the second body inclined surface 111b formed in the region B. The cover portion 113 is formed to have a thickness capable of covering the Zener diode 140 disposed in the region B, and formed to a degree not to exceed a stepped portion 112. Also, as shown in the drawings, the cover portion 113 may have a cover inclined surface 113b formed as a gently inclined surface. The cover inclined surface 113b may be formed as a curved surface, and may be formed such that a slope becomes gentle from an upper portion to a lower portion.

Herein, the cover portion 113 is described as being formed not to exceed the stepped portion 112, but is not limited thereto, and a portion of the cover portion 113 may be formed beyond the stepped portion 112 to a position where the light emitting diode chip 120 is mounted, if necessary. That is, the cover portion 113 may be formed to cover the second body inclined surface 111b and the Zener diode 140 using a viscous material containing a reflective material. In this case, the reflective material may be TiO₂, Al₂O₃, and the like.

As the cover portion 113 is formed in the region B in this way, the cover inclined surface 113b formed in the cavity V of the light emitting diode package 100 may be formed in a shape similar to that of the first body inclined surface 111a. Accordingly, all surfaces of a reflection surface formed in the cavity V may be formed to be substantially same with respect to the light emitting diode chip 120.

The coating portion 115 is formed to cover the first body inclined surface 111a and the cover inclined surface 113b using a coating material containing a reflective material. In this case, the reflective material may be TiO₂, Al₂O₃, and the like. That is, the coating portion 115 may be formed to cover all regions in the cavity V of the light emitting diode package 100 except for the light emitting diode chip 120. To this end, the coating portion 115 may be formed on the first body inclined surface 111a and the cover inclined surface 113b by using various methods such as spraying, dispensing, jetting, film attaching, sputtering, e-beam deposition, and the like, which may be performed above the cavity V of the light emitting diode package 100, with an upper portion of the light emitting diode chip 120 masked. Accordingly, a first coating inclined surface 115a may be formed in the region A of the cavity V of the light emitting diode package 100, and a second coating inclined surface 115b may be formed in the region B.

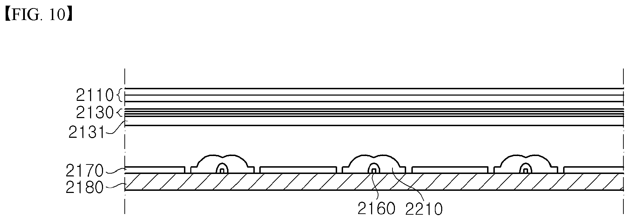

FIG. 10 is a cross-sectional view illustrating a display apparatus to which a light emitting diode according to an embodiment of the present disclosure is applied.

The display apparatus of this embodiment includes a display panel 2110, a backlight unit providing light to the display panel 2110, and a panel guide supporting a lower edge of the display panel 2110.

The display panel 2110 is not particularly limited, and may be, for example, a liquid crystal display panel including a liquid crystal layer. A gate driving PCB for supplying a driving signal to a gate line may be further disposed at the edge of the display panel 2110. Herein, the gate driving PCB may not be configured in an additional PCB, but may be formed on a thin film transistor substrate.

The backlight unit includes a light source module including at least one substrate and a plurality of light emitting devices 2160. Furthermore, the backlight unit may further include a base substrate 2180, a reflection unit 2170, a diffusion plate 213, and optical sheets 2130.

The base substrate 2180 may be opened upward and accommodate the substrate, the light emitting device 2160, the reflection sheet 2170, the diffusion plate 2131, and the optical sheets 2130. In addition, the base substrate 2180 may be coupled with the panel guide. The base substrate 2180 may be disposed under the reflection unit 2170, and the light emitting device 2160 may be disposed surrounded by the reflection unit 2170. However, without being limited thereto, the light emitting device 2160 may be disposed on the reflection unit 2170 when a reflective material is coated on a surface of the base substrate 2180. In addition, a plurality of substrates may be formed, and the plurality of substrates may be disposed in a form flush with one another but the inventive concepts are not limited thereto, and the backlight unit may include a single substrate.

The light emitting device 2160 may include the light emitting diode according to the above-described embodiments of the present disclosure. The light emitting devices 2160 may be regularly arranged in a predetermined pattern on the substrate. The light emitting devices 2160 may be arranged in a square shape, or in another form, may be staggered so as not to overlap adjacent light emitting devices 2160.

In addition, a light guide 2210 may be disposed on each of the light emitting devices 2160, thereby improving uniformity of light emitted from the plurality of light emitting devices 2160. The light guide 2210 may be one of materials such as Si, a lens, and a resin including a phosphor. The light guide 2210 may have an upper surface parallel to the base substrate 2180, or may have a convex curved surface.

The diffusion plate 2131 and the optical sheets 2130 are disposed on the light emitting device 2160. Light emitted from the light emitting device 2160 may be supplied to the display panel 2110 in a form of a surface light source via the diffusion plate 2131 and the optical sheets 2130.

As such, the light emitting device according to the embodiments of the present disclosure may be applied to a direct-type display apparatus as the present embodiment.

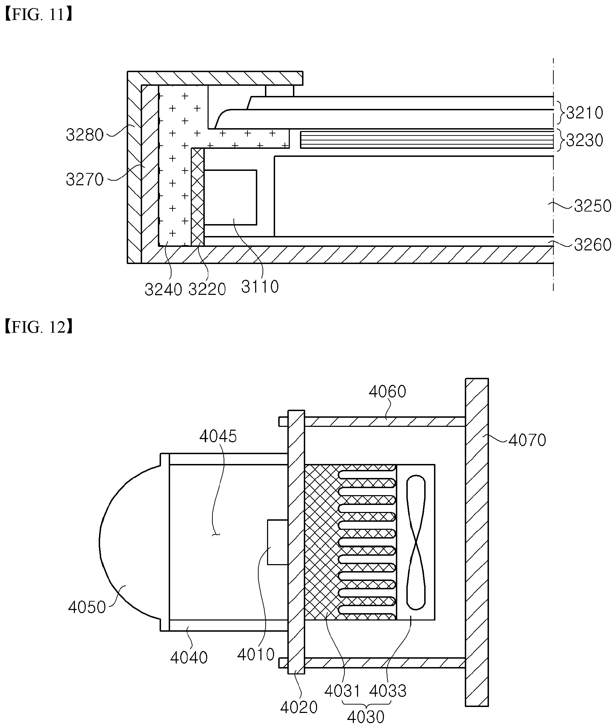

FIG. 11 is a cross-sectional view illustrating a display apparatus to which a light emitting diode according to another embodiment of the present disclosure is applied.

The display apparatus having a backlight unit according to this embodiment includes a display panel 3210 on which an image is displayed, and a backlight unit disposed on a rear surface of the display panel 3210 to emit light. Furthermore, the display apparatus includes a frame 3240 supporting the display panel 3210 and accommodating the backlight unit, and covers 3270 and 3280 surrounding the display panel 3210.

The display panel 3210 is not particularly limited, and may be, for example, a liquid crystal display panel including a liquid crystal layer. A gate driving PCB for supplying a driving signal to a gate line may be further disposed at an edge of the display panel 3210. Herein, the gate driving PCB may not be configured in an additional PCB, but may be formed on a thin film transistor substrate. The display panel 3210 is secured by the covers 3270 and 3280 disposed under and over the display panel 3210, and the cover 3270 disposed under the display panel 3210 may be coupled to the backlight unit.

The backlight unit providing light to the display panel 3210 includes a lower cover 3270 having a partially opened upper surface, a light source module disposed on an inner side of the lower cover 3270, and a light guide plate 3250 disposed in parallel with the light source module to convert point light into surface light. In addition, the backlight unit of this embodiment may further include optical sheets 3230 disposed on the light guide plate 3250 to diffuse and condense light, and a reflection sheet 3260 disposed under the light guide plate 3250 to reflect light proceeding in a lower direction of the light guide plate 3250 toward the display panel 3210.

The light source module includes a substrate 3220 and a plurality of light emitting devices 3110 disposed apart from one another at regular intervals on one surface of the substrate 3220. The substrate 3220 is not limited as long as it supports the light emitting device 3110 and is electrically connected to the light emitting device 3110, and may be, for example, a printed circuit board. The light emitting device 3110 may include at least one light emitting diode according to the above-described embodiments of the present disclosure. Light emitted from the light source module is incident on the light guide plate 3250 and supplied to the display panel 3210 through the optical sheets 3230. Through the light guide plate 3250 and the optical sheets 3230, a point light source emitted from the light emitting devices 3110 may be transformed into a surface light source.

As such, the light emitting device according to the embodiments of the present disclosure may be applied to an edge-type display apparatus as the present embodiment.

FIG. 12 is a cross-sectional view illustrating an example of applying a light emitting diode to a headlamp according to another embodiment of the present disclosure.

Referring to FIG. 12, the headlamp includes a lamp body 4070, a substrate 4020, a light emitting device 4010, and a cover lens 4050. Furthermore, the headlamp may further include a heat dissipation unit 4030, a support rack 4060, and a connection member 4040.

The substrate 4020 is secured by the support rack 4060 and disposed apart over the lamp body 4070. The substrate 4020 is not limited as long as it can support the light emitting device 4010, and may be, for example, a substrate having a conductive pattern such as a printed circuit board. The light emitting device 4010 may be disposed on the substrate 4020, and supported and secured by the substrate 4020. In addition, the light emitting device 4010 may be electrically connected to an external power source through the conductive pattern of the substrate 4020. In addition, the light emitting device 4010 may include at least one light emitting diode according to the above-described embodiments of the present disclosure.

The cover lens 4050 is disposed on a path along which light emitted from the light emitting device 4010 moves. For example, as shown in the drawings, the cover lens 4050 may be disposed apart from the light emitting device 4010 by the connection member 4040, and disposed in a direction in which light emitted from the light emitting device 4010 is to be provided. A viewing angle and/or color of light emitted from the headlamp to the outside may be adjusted by the cover lens 4050. Meanwhile, the connection member 4040 secures the cover lens 4050 to the substrate 4020, and may serve as a light guide by being disposed to surround the light emitting device 4010 and providing a light emitting path 4045. In this case, the connection member 4040 may be formed of a light reflective material or coated with a light reflective material. Meanwhile, the heat dissipation unit 4030 may include a heat dissipation fin 4031 and/or a heat dissipation fan 4033, and may dissipate heat generated to the outside when the light emitting device 4010 is driven.

As such, the light emitting device according to the embodiments of the present disclosure may be applied to the headlamp as in the present embodiment, in particular, a headlamp for a vehicle.

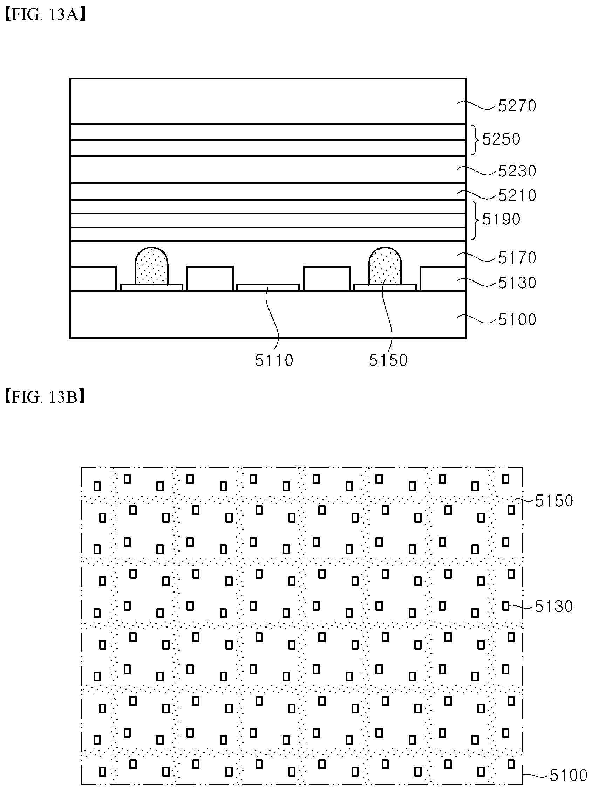

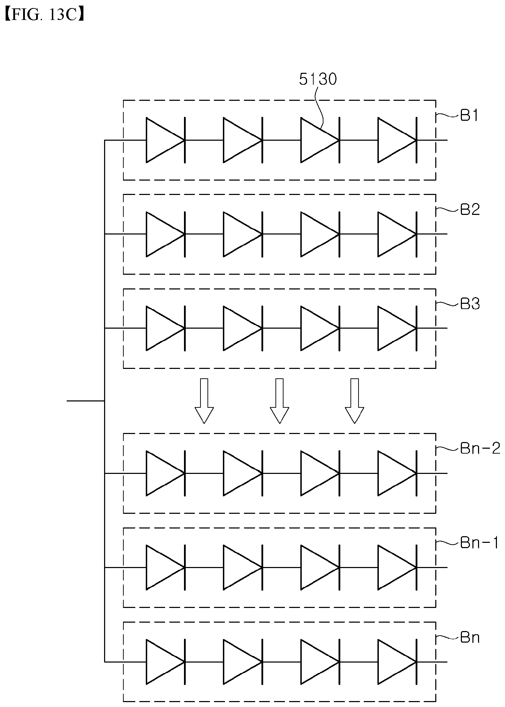

FIGs. 13A, 13B, and 13C are a schematic cross-sectional view, a plan view, and a circuit diagrams illustrating a display apparatus to which a light emitting diode according to another embodiment of the present disclosure is applied. FIG. 13A shows a partial cross-sectional view of the display apparatus, FIG. 13B shows a plan view of a backlight unit, and FIG. 13C shows a circuit diagram of the backlight unit.

Referring to FIGs. 13A, 9B, and 9C, the display apparatus of this embodiment includes a display panel 5270 and a backlight unit providing light to the display panel 5270.

The display panel 5270 is not particularly limited, and may be, for example, a liquid crystal display panel including a liquid crystal layer. A gate driving PCB for supplying a driving signal to a gate line may be further disposed at an edge of the display panel 5270. Herein, the gate driving PCB may not be configured in an additional PCB, but may be formed on a thin film transistor substrate.

The backlight unit may include a circuit board 5100, a reflection unit 5110, a light emitting device 5130, a dam portion 5150, a molding member 5170, a diffusion film 5190, and a blue light transmittance (BLT) film, a quantum dot (QD) film 5230, and a brightness enhancement film 5250.

The backlight unit includes a circuit board 5100 and a light source module including a plurality of light emitting devices 5130 disposed on the circuit board 5100. One light source module may be used as the backlight unit, or a plurality of light source modules may be arranged on a plane and used as the backlight unit.

The reflection unit 5110 may be disposed on a surface of the circuit board 5100, as shown in FIG. 13A. The reflection unit 5110 may be provided as a reflection sheet or coated on the circuit board 5100. The reflection unit 5110 may surround the light emitting devices 5130 by being formed around a region where the light emitting devices 5130 are mounted. However, the inventive concepts are not limited thereto, and the light emitting devices 5130 may be disposed on the reflection unit 5110.

The circuit board 5100 has circuits for supplying power to the light emitting devices 5130. The light emitting devices 5130 may be connected in series, parallel, or series-parallel through circuits formed on the circuit board 5100. An electrical connection structure of the light emitting devices 5130 will be described later with reference to FIG. 13C.

The light emitting device 5130 may include the light emitting diode previously described with reference to FIGs. 1A and 1B or 5A and 5B, and a detailed description thereof will be omitted.

The dam portion 5150 is formed on the circuit board 5100. The dam portion 5150 divides a region on the circuit board 5100 into a plurality of blocks, as shown in FIG. 17B. The plurality of light emitting devices 5130 may be disposed in each of the blocks. For example, in this embodiment, four light emitting devices 5130 are disposed in each of the blocks. However, the inventive concepts are not limited thereto, and more or fewer light emitting devices 5130 than four may be disposed in each of the blocks.

The dam portion 5150 may include a reflective material that reflects light generated by the light emitting devices 5130, and may be formed of, for example, white silicone.

The molding member 5170 fills the blocks partitioned by the dam portion 5150. The molding member 5170 may be formed of transparent silicone. The dam portion 5150 and the molding member 5170 may include silicone of a same series, and may be formed of, for example, phenyl or methyl-based. Since the dam portion 5150 and the molding member 5170 include the same type of silicone, bonding force between the molding member 5170 and the dam portion 5150 may be improved.

The diffusion film 5190 is disposed on the molding member 5170. The diffusion film 5190 diffuses light generated by the light emitting devices 5130 to evenly diffuse light. The diffusion film 5190 may adhere to the molding member 5170, but is not limited thereto, and may be spaced apart from the molding member 5170. The diffusion film 5190 may be composed of one sheet, or may be composed of a plurality of sheets as shown in FIG. 13A.

The BLT film 5210 and the QD film 5230 may be disposed on the diffusion film 5190. The QD film 5230 includes quantum dots that convert light emitted from the light emitting devices 5130, for example, blue light into green light and red light.

The BLT film 5210 transmits light emitted from the light emitting devices 5130, such as blue light, and reflects green light and red light generated from the QD film 5230. Accordingly, it is possible to prevent green light and red light generated from the QD film 5230 from being lost while proceeding toward the circuit board 5100.

Meanwhile, the brightness enhancement film 5250 is disposed on the QD film 5230 to improve brightness of light proceeding to the display panel 5270. The brightness enhancement film 5250 may include lower and upper brightness enhancement films, and may further include a dual brightness enhancement film (DBEF).

As shown in FIG. 13B, the light emitting devices 5130 are disposed in blocks partitioned by the dam portion 5150. The light emitting devices 5130 in a same block may be spaced apart from one another at equal intervals. In addition, the light emitting devices 5130 in adjacent blocks may also be spaced apart at similar intervals. As shown in FIG. 13B, the light emitting devices in one block may be disposed in a tilted shape with respect to a rectangular block.

Meanwhile, as shown in FIG. 13C, the light emitting devices 5130 arranged in each block B1 through Bn may be serially connected to one another. In addition, anodes of the light emitting devices in a first to nth blocks may be connected to one another, and cathodes may be spaced apart from one another. For example, anodes of the light emitting devices in a first block B1 and anodes of the light emitting devices in a second block B2 are connected to one another, and cathodes of the light emitting devices in the first block B1 and cathodes of the light emitting devices in the second block B2 are electrically spaced apart from one another. Accordingly, the light emitting devices 5130 may be independently driven in block units.

According to this embodiment, as the light emitting devices 5130 are independently driven in block units, for example, a black region may be implemented by turning off the light emitting devices 5130. Accordingly, contrast may be implemented more clearly, and power consumption may be reduced compared to a conventional LCD display in which the backlight source is always turned on. Furthermore, by using the QD film, vivid colors may be implemented.

As such, the light emitting device according to the embodiments of the present disclosure may be applied to a mini LED display apparatus as the present embodiment.

Although some exemplary embodiments have been described above, it should be understood that these embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A light emitting diode, comprising:
a substrate;
a first conductivity type semiconductor layer disposed on the substrate;
a mesa disposed on the first conductivity type semiconductor layer, and including an active layer and a second conductivity type semiconductor layer;
an ohmic contact layer disposed on the second conductivity type semiconductor layer and formed of islands spaced apart from one another;
a dielectric layer covering the ohmic contact layer, and having openings respectively exposing the islands;
a metal reflection layer covering the dielectric layer, and electrically connected to the islands through the openings of the dielectric layer;
a lower insulation layer covering the metal reflection layer, and having an opening exposing the metal reflection layer; and
first and second bump pads disposed over the lower insulation layer, and electrically connected to the first and second conductivity type semiconductor layers, respectively.

2. The light emitting diode of claim 1, wherein:
The dielectric layer covers the islands and the second conductivity type semiconductor layer exposed between the islands, and
the openings of the dielectric layer exposing the ohmic contact layer are respectively disposed on the islands to partially expose the islands.

3. The light emitting diode of claim 1,
wherein each of the islands has a circular shape, a diameter of each of the islands exceeds four times of diameters of the openings of the dielectric layer, and an interval between the islands is equal to or larger than the diameters of the openings.

4. The light emitting diode of claim 3, wherein:
wherein the interval between the islands is smaller than the diameter of the island.

5. The light emitting diode of claim 1,
wherein the lower insulation layer includes a distributed Bragg reflector.

6. The light emitting diode of claim 1, further comprising:
a first pad metal layer disposed on the lower insulation layer, and electrically connected to the first conductivity type semiconductor layer; and
a second pad metal layer disposed on the lower insulation layer, and electrically connected to the metal reflection layer through the opening of the lower insulation layer.

7. The light emitting diode of claim 6, further comprising:
an upper insulation layer covering the first pad metal layer and the second pad metal layer, and including a first opening exposing the first pad metal layer and a second opening exposing the second pad metal layer,
wherein the first and second bump pads are electrically connected to the first and second pad metal layers through the first and second openings, respectively.

8. The light emitting diode of claim 7, wherein:
the mesa has via holes exposing the first conductivity type semiconductor layer,
the dielectric layer and the lower insulation layer are formed to expose the first conductivity type semiconductor layer in the via holes, and
the first pad metal layer has internal contact portions contacting the first conductivity type semiconductor layer in the via holes.

9. The light emitting diode of claim 8, wherein:
the mesa has a side surface having recess portions,
an edge of the lower insulation layer is formed along an edge of the mesa to expose the first conductivity type semiconductor layer along a periphery of the mesa, and
the first pad metal layer has external contact portions contacting the first conductivity type semiconductor layer near the recess portions.

10. The light emitting diode of claim 9,
wherein the first pad metal layer further compromises an external contact portion contacting the first conductivity type semiconductor layer near at least some of edges of the substrate.

11. The light emitting diode of claim 1, further comprising:
a rim dielectric layer laterally spaced apart from the dielectric layer and disposed along an edge of the first conductivity type semiconductor layer.

12. The light emitting diode of claim 11,
wherein the rim dielectric layer is formed of a same material as that of the dielectric layer.

13. The light emitting diode of claim 11,
wherein the rim dielectric layer is laterally spaced apart from the lower insulation layer.

14. The light emitting diode of claim 13, further comprising:
a first pad metal layer disposed on the lower insulation layer, and electrically connected to the first conductivity type semiconductor layer; and
a second pad metal layer disposed on the lower insulation layer, and electrically connected to the metal reflection layer through the opening of the lower insulation,
wherein the rim dielectric layer is laterally spaced apart from the first pad metal layer.

15. The light emitting diode of claim 14, further comprising:
an upper insulation layer covering the first pad metal layer and the second pad metal layer, and including a first opening exposing the first pad metal layer and a second opening exposing the second pad metal layer, wherein:
the first and second bump pads are electrically connected to the first and second pad metal layers through the first and second openings, and
the upper insulation layer covers the rim dielectric layer.

16. The light emitting diode of claim 1,
wherein the ohmic contact layer is formed of a conductive oxide layer.

17. The light emitting diode of claim 16,
wherein the conductive oxide layer is ITO (Indium Tin Oxide).

18. A light emitting diode, comprising:
a first conductivity type semiconductor layer;
a mesa disposed on the first conductivity type semiconductor layer, and including an active layer and a second conductivity type semiconductor layer;
an ohmic contact layer disposed on the second conductivity type semiconductor layer and formed of islands spaced apart from one another;
a dielectric layer covering the ohmic contact layer, and having openings respectively exposing the islands;
a metal reflection layer covering the dielectric layer, and electrically connected to the islands through the openings of the dielectric layer; and
a lower insulation layer covering the metal reflection layer, and having an opening exposing the metal reflection layer.

19. The light emitting diode of claim 18,
wherein the ohmic contact layer is formed of ITO.

20. The light emitting diode of claim 18,
wherein the dielectric layer and the lower insulation layer cover a side surface of the mesa, and partially cover the first conductivity type semiconductor layer exposed around the mesa along an edge of the mesa.
